Europäisches Patentamt

European Patent Office

Office européen des brevets

(11) Veröffentlichungsnummer: **0 389 862**

**A2**

(12) **EUROPÄISCHE PATENTANMELDUNG**

(21) Anmeldenummer: 90104736.5

(51) Int. Cl.5: **H01L 29/74, H03K 17/73**

(22) Anmeldetag: **13.03.90**

(30) Priorität: **29.03.89 DE 3910167**

(43) Veröffentlichungstag der Anmeldung:
**03.10.90 Patentblatt 90/40**

(84) Benannte Vertragsstaaten:
**CH DE FR GB IT LI SE**

(71) Anmelder: **Siemens Aktiengesellschaft**
**Wittelsbacherplatz 2**
**D-8000 München 2(DE)**

(72) Erfinder: **Oppermann, Klaus-Günter,**
**Dipl.-Phys.**
**Föchinger Strasse 12**
**D-8150 Holzkirchen(DE)**
Erfinder: **Schwarzbauer, Herbert, Dr.**
**Kössener Strasse 13 a**
**D-8000 München 70(DE)**
Erfinder: **Stengl, Reinhard, Dr. Dipl.-Phys.**
**Herzogstrasse 40**
**D-8000 München 40(DE)**

(54) **Abschaltbarer Thyristor.**

(57) Ein Emitter des Thyristors ist in eine Vielzahl von Emittergebieten (2 bis 5) aufgeteilt. Diese werden in einer Hauptfläche (1a) des Thyristors von ersten Elektroden (10 bis 13) kontaktiert, die über individuell zugeordnete Widerstandselemente (Rv) mit einem Hauptanschluß (K) des Thyristors verbunden sind. Neben den Emittergebieten sind weitere Elektroden (14 bis 17) vorgesehen, über die jeweils parallele Abschaltstrompfade (18 bis 21) von der an die Emittergebiete angrenzenden Basis (6) über Feldeffekttransistoren (T1 bis T4) zu dem genannten Hauptanschluß (K) hin verlaufen. Durch die Widerstandselemente (Rv) wird sichergestellt, daß sich die auf die einzelnen Emittergebiete (2 bis 5) entfallenden Laststromanteile sämtlich zuverlässig abschalten lassen.

FIG 1

EP 0 389 862 A2

## Abschaltbarer Thyristor.

Die Erfindung bezieht sich auf einen abschaltbaren Thyristor nach dem Oberbegriff des Patentanspruchs 1.

Bei einem aus der DE-OS 28 25 794 bekannten Thyristor dieser Art ist für die Wirksamschaltung aller Abschaltstrompfade ein einziger, allen gemeinsamer Kurzschlußthyristor vorgesehen. Die den ersten Elektroden individuell zugeordneten Widerstandselemente sind hier erforderlich, um trotz der Durchlaßspannung des Kurzschlußthyristors, die zum Beispiel 2 Volt beträgt, eine Abschaltung des Thyristors zu ermöglichen. Würde nämlich die an den Abschaltstrompfaden liegende Spannung nur aus der im leitenden Zustand des Thyristors vorhandenen Durchlaßspannung des pn-Übergangs zwischen einem Emittergebiet und der angrenzenden Basis bestehen, die etwa 0,6 bis 0,8 Volt beträgt, so würde das nicht ausreichen, um den Kurzschlußthyristor im leitenden Zustand zu betreiben. Daher erhöht man die an den Abschaltstrompfaden liegende Spannung um den Betrag des Spannungsabfalls, der infolge des Thyristor-Laststroms an einem der Widerstandselemente entsteht.

Der Erfindung liegt die Aufgabe zugrunde, einen abschaltbaren Thyristor der eingangs genannten Art anzugeben, bei dem trotz einer getrennten Wirksamschaltung jedes einzelnen Abschaltpfades mit Schaltelementen wesentlich niedrigerer Durchlaßspannung als bei dem vorstehend erwähnten Thyristor eine thermische Zerstörung beim Abschalten sicher vermieden wird. Das wird erfindungsgemäß durch die Merkmale des kennzeichnenden Teils des Patentanspruchs 1 erreicht.

Der mit der Erfindung erzielbare Vorteil liegt insbesondere darin, daß wegen der Vielzahl der getrennt wirksam schaltbaren, zueinander parallelen Abschaltstrompfade eine Abschaltung des Thyristors auch bei großen Lastströmen problemlos erfolgt, ohne daß stark ungleichmäßige Abschaltstrombelastungen in den Bereichen der einzelnen Emittergebiete auftreten, so daß eine thermische Zerstörung des Thyristors ausgeschlossen ist.

Aus der DE-OS 26 25 917 ist zwar ein abschaltbarer Thyristor mit einer Mehrzahl von parallelen Abschaltstrompfaden bekannt, die durch Feldeffekttransistoren jeweils getrennt wirksam geschaltet werden, doch kann bei diesem Thyristor zum Beispiel durch Ausbildung eines Stromfilaments einer dieser Abschaltstrompfade nicht mehr abschaltbar sein, wobei eine solche Abschaltstromüberhöhung auftreten kann, daß die Gefahr einer thermischen Überlastung besteht.

Die Patentansprüche 2 bis 6 sind auf bevorzugte Ausgestaltungen und Weiterbildungen der Erfindung gerichtet.

Die Erfindung wird nachfolgend anhand der Zeichnung näher erläutert. Dabei zeigt:

Figur 1 die Prinzipdarstellung eines Ausführungsbeispiels der Erfindung und

Figur 2 eine bevorzugte Ausgestaltung des Ausführungsbeispiels nach Figur 1.

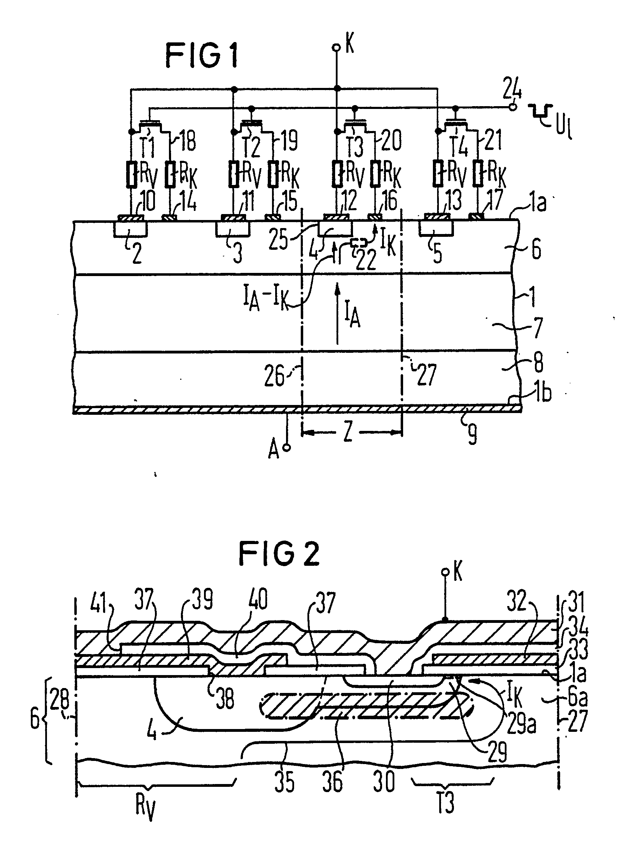

In Figur 1 ist ein abschaltbarer Thyristor mit einem aus dotiertem Halbleitermaterial, z. B. Silizium, bestehenden Halbleiterkörper 1 dargestellt. Er weist vier aufeinanderfolgende Schichten abwechselnder Leitungstypen auf. Von diesen bezeichnet man die aus den nicht miteinander verbundenen, n-leitenden Emittergebieten 2 bis 5 bestehende Schicht als den n-Emitter, die p-leitende Schicht 6 als die p-Basis, die n-leitende Schicht 7 als die n-Basis und die p-leitende Schicht 8 als den p-Emitter. Die Emittergebiete 2 bis 5 sind so in die p-Basis 6 eingefügt, daß sie sich bis zur oberen Hauptfläche 1a des Halbleiterkörpers 1 erstrecken und in dieser von ersten, kathodenseitigen Elektroden 10 bis 13 aus elektrisch leitendem Material, z. B. Aluminium, kontaktiert werden. Diese Elektroden sind über individuell zugeordnete Widerstandselemente Rv mit einem ersten Hauptanschluß K des Thyristors verbunden. Der p-Emitter 8 wird in der unteren Hauptfläche 1b des Halbleiterkörpers von einer anodenseitigen Elektrode 9 aus elektrisch leitendem Material, z. B. Aluminium, kontaktiert, die mit einem Hauptanschluß A verbunden ist. In der Hauptfläche 1a sind neben den Emittergebieten 2 bis 5 jeweils dritte Elektroden 14 bis 17 aus elektrisch leitendem Material, z. B. Aluminium, angeordnet, über die Abschaltstrompfade 18 bis 21 verlaufen, welche die von den Elektroden 14 bis 17 kontaktierten Stellen der p-Basis 6 jeweils mit dem Hauptanschluß K verbinden. Jeder der Abschaltstrompfade, z. B. 20, enthält einen Kurzschlußwiderstand $R_K$, dessen Bedeutung weiter unten erläutert werden soll.

Im leitenden Zustand des Thyristors entfällt auf jedes Emittergebiet, z. B. 4, ein Laststromanteil $I_A$. Zum Zwecke des Abschaltens des Thyristors werden alle zueinander parallelen Abschaltstrompfade, z. B. 18 bis 21, über Feldeffekttransistoren, z. B. T1 bis T4, gleichzeitig wirksam geschaltet, was durch Zuführung eines Löschimpulses $U_I$ an den gemeinsamen Gateanschluß 24 aller Feldeffekttransistoren geschieht, der diese in den leitenden Zustand schaltet. Dabei teilt sich der auf ein Emittergebiet, z. B. 4, entfallende Laststromanteil $I_A$ in zwei Komponenten. Die erste Komponente besteht aus dem Kurzschlußstrom $I_K$, der über den wirksam geschalteten Abschaltstrompfad, z. B. 20, unter Umgehung des Emittergebiets dem Hauptanschluß K

2

zugeführt wird, während die zweite Komponente $I_A - I_K$ weiter über das betreffende Emittergebiet und das in Serie zu diesem geschaltete Widerstandselement Rv nach K fließt. Der Kurzschlußwiderstand $R_K$ stellt dabei jeweils den Widerstand 22 in der p-Basis 6 dar, der von dem Kurzschlußstrom $I_K$ durchflossen wird. Die in den einzelnen Abschaltstrompfaden, z. B. 18 bis 21, fließenden, ersten Komponenten $I_K$ bilden in ihrer Gesamtheit den Abschaltstrom des Thyristors.

Bezeichnet man $I_A/I_K$ als den Abschaltverstärkungsfaktor $\beta$, so kann man für jedes Emittergebiet einen strukturell bedingten, maximalen Abschaltverstärkungsfaktor $\beta_{max}$ angeben, bei dem der über dasselbe fließende Laststromanteil $I_A$ gerade noch abge schaltet werden kann. Der maximal abschaltbare Laststromanteil $I_{Amax}$ ergibt sich dann, wenn man das Widerstandselement Rv nicht berücksichtigt, zu:

$$I_{Amax} = \beta_{max} \cdot I_{Kmax} = \beta_{max} \cdot \frac{U_J}{R_K} \qquad (1)$$

Dabei bedeuten $I_{Kmax}$ den maximalen Kurzschlußstrom, $U_J$ den konstanten, etwa 0,6 bis 0,8 Volt betragenden Spannungsabfall am pn-Übergang 25 zwischen dem Emittergebiet 4 und der p-Basis 6 im leitenden Zustand des Thyristors und $R_K$ den Wert des von $I_K$ durchlaufenen Widerstandes 22 in der p-Basis. Somit läßt sich $I_{Amax}$ ausschließlich durch strukturell bedingte, konstante Größen beschreiben.

Fließt ein $I_{Amax}$ übersteigender Laststromanteil durch das betrachtete Emittergebiet, z. B. 4, so läßt sich dieser Laststromanteil durch die Wirksamschaltung des zugehörigen Abschaltstrompfades, z. B. 20, nicht mehr abschalten. Geht man von einer gleichmäßigen Verteilung des Laststroms auf alle Emittergebiete aus, wobei auf jedes derselben ein gleich großer Laststromanteil $I_A$ entfällt, so könnte man gemäß der Beziehung (1) einen den strukturellen Gegebenheiten Rechnung tragenden maximalen Laststromanteil $I_{Amax}$ angeben, der an allen Emittergebieten noch sicher abgeschaltet werden könnte. Da aber in der Praxis immer eine nicht genau zu kontrollierende, ungleichmäßige Aufteilung des Laststroms auf die einzelnen Emittergebiete vorhanden ist, z. B. durch Ausbildung eines Stromfilamentes, führt das sehr leicht dazu, daß die auf einzelne oder mehrere Emittergebiete entfallenden Laststromanteile nicht mehr abgeschaltet werden können, weil sie den jeweiligen Wert von $I_{Amax}$ überschreiten. Das würde aber mit großer Sicherheit zu einer thermischen Zerstörung des Thyristors führen.

Nach der Erfindung wird dieses Problem dadurch gelöst, daß in die Verbindungen zwischen den die Emittergebiete kontaktierenden Elektroden, z. B. 10 bis 13, und den Hauptanschluß K jeweils die genannten Widerstandselemente Rv eingefügt werden, und zwar derart, daß sie den Abschaltstrompfad, z. B. 18 bis 21, und insbesondere auch den in diesen enthaltenen Feldeffekttransistoren jeweils parallel geschaltet sind. Damit liegt an jedem Abschaltstrompfad, z. B. 20, eine Spannung an, die der Summe aus dem konstanten Spannungsabfall $U_J$ und einem laststromabhängigen Spannungsabfall $U_V$ entspricht, der infolge der Stromkomponente $I_A - I_K$ an dem zusätzlich vorgesehenen Widerstandselement Rv abfällt. Für die Abschaltung des Thyristors ist nun nicht mehr die Beziehung (1) maßgebend, weil die konstante Spannung $U_J$ durch die Summenspannung aus $U_J$ und $U_V$ ersetzt wird, wobei aber $U_V$ dem jeweiligen Wert von $I_A - I_K$ proportional ist. Es läßt sich zeigen, daß z. B. bei gleich großen Widerständen $R_K$ und Rv auch für sehr große Laststromanteile $I_A$ der Abschaltverstärkungsfaktor $\beta$ zwar einen oberen Grenzwert 2 erreicht, diesen aber nicht übersteigt. Legt man also die Thyristorstruktur so aus, daß sich für $\beta_{max}$ z. B. Werte von 2 oder 3 ergeben, ist eine Abschaltung des Thyristors in den Bereichen aller Emittergebiete auch bei sehr großen Lastströmen sicher gewährleistet, so daß eine thermische Zerstörung des Thyristors ausgeschlossen ist.

Der Thyristor nach Figur 1 weist eine Vielzahl von einzelnen Zellen Z auf, die jeweils dem zwischen den strichpunktierten Linien 26 und 27 liegenden Teil der dargestellten Struktur entsprechen und untereinander gleichartig aufgebaut sind. Die Halbleiterschichten 6, 7 und 8 sowie die Elektrode 9 stellen dabei Teile dar, die sich in lateraler Richtung über den ganzen Thyristorquerschnitt erstrecken und somit allen Zellen Z gemeinsam sind.

Nach einer bevorzugten Ausgestaltung der Erfindung sind die Widerstandselemente Rv, die zugeordneten Feldeffekttransistoren, z. B. T3 und die Abschaltstrompfade, z. B. 20, in die jeweiligen Zellen Z integriert. Figur 2 zeigt einen zweckmäßigen Aufbau einer solchen Zelle am Beispiel der in Figur 1 von den Linien 26 und 27 begrenzten Teilstruktur, wobei aber nur eine Zellenhälfte dargestellt ist. Die strichpunktierte Linie 28 bedeutet eine senkrecht zur Bildebene stehende Symmetrieebene, die durch die Zellenmitte verläuft. Das Emittergebiet 4 hat vorzugsweise einen lateralen Querschnitt, der einem Kreisring oder etwa einem rechteckförmigen Rahmen entspricht. Der in Figur 2 dargestellte Querschnitt von 4 gehört dann zu dem rechten Teil des in sich geschlossenen Emittergebiets. Andererseits kann das Emittergebiet 4 auch in lateraler Richtung eine Streifenform aufweisen, wobei die Längsrichtung des Streifens senkrecht zur Bildebene von Figur 2 steht. In diesem Fall ist links von der Symmetrieebene 28 ein zweites streifenförmiges Emittergebiet angeordnet, das einen weiteren, unabhängigen aber elektrisch parallel geschalteten Teil des Emittergebiets 4 von Figur 1 darstellt.

Rechtsseitig vom Emittergebiet 4, das eine Dotierungskonzentration von etwa $10^{19}$ $cm^{-3}$ aufweist, ist eine n-dotierte Halbleiterzone 29 mit einer Dotierungskonzentration von z. B. 5 . $10^{17}$ $cm^{-3}$ in die p-Basis 6 eingefügt, die mit etwa $10^{16}$ $cm^{-3}$ dotiert ist. In diese Zone 29 ist ein p-leitendes Gebiet 30 eingefügt, das zum Beispiel eine Dotierungskonzentration von $10^{19}$ $cm^{-3}$ aufweist. Das Gebiet 30 wird in der Hauptfläche 1a von einer leitenden Belegung 31 kontaktiert, die mit dem Hauptanschluß K des Thyristors verbunden ist. Der rechtsseitig neben der Zone 29 liegende Teil 6a der p-Basis stellt das Sourcegebiet und das Gebiet 30 das Draingebiet des Feldeffekttransistor T3 dar, dessen Kanalgebiet durch den zwischen 6a und 30 liegenden Randbereich der Zone 29 gebildet wird. Oberhalb dieses Randbereichs ist eine Gateelektrode 32 angeordnet, die durch eine dünne elektrisch isolierende Schicht 33, z. B. aus $SiO_2$, von der Hauptfläche 1a getrennt ist. Diese Gateelektrode ist mit dem in Figur 2 nicht dargestellten Anschluß 24 (Figur 1) verbunden. Wird 32 über den Anschluß 24 mit einem negativen Löschimpuls $U_l$ beaufschlagt, so bildet sich unterhalb von 32 im Randbereich der Zone 29 ein Inversionskanal 29a aus, der die Teile 6a und 30 niederohmig miteinander verbindet. Zwischen der Gateelektrode 32 und dem darüberliegenden Teil der leitenden Belegung 31 befindet sich eine Zwischenisolationsschicht 34, z. B. aus $SiO_2$. Der Weg des Kurzschlußstroms $I_K$ ist in Figur 2 mit dem Pfeil 35 angedeutet. Um sicherzustellen, daß die diesen Kurzschlußstrom im Bereich der p-Basis 6 bildenden, positiven Ladungsträger im wesentlichen längs des durch 35 angedeuteten Weges transportiert werden, ist es zweck mäßig, in die p-Basis 6 eine Abschirmzone 36 einzufügen, die sich rechtsseitig an das Emittergebiet 4 anschließt und unterhalb des Gebiets 30 angeordnet ist, ohne daß sie dieses berührt. Die Abschirmzone 36 besteht vorzugsweise aus einem durch Ionenimplantation erzeugten, $n^+$-dotierten Gebiet oder z. B. auch aus $SiO_2$.

Zur Integration des Widerstandselements Rv ist auf der Hauptfläche 1a eine dünne, elektrisch isolierende Schicht 37 vorgesehen, die im Bereich des Emittergebiets 4 mit einem Kontaktloch 38 versehen ist. Eine auf der Schicht 37 angeordnete Belegung 39 aus einem widerstandsbehafteten Material, z. B. aus polykristallinem Silizium, kontaktiert das Emittergebiet 4 im Bereich des Kontaktlochs 38. Eine die Belegung 39 abdeckende, elektrisch isolierende Schicht 40, z. B. aus $SiO_2$, ist mit einem Kontaktloch 41 versehen, in dem die Belegung 39 von der leitenden Belegung 31 kontaktiert wird. Der zwischen den Kontaktlöchern 38 und 41 liegende Teil der Belegung 39 stellt den Widerstand Rv dar. Zweckmäßigerweise besteht die Gateelektrode 32 ebenfalls aus polykristallinem Silizium, so daß sie zugleich mit der Belegung 39 auf die Schichten 33 und 37 aufgebracht werden kann.

Weitere Ausführungsformen der Erfindung ergeben sich dadurch, daß sämtliche Halbleitergebiete bzw. -schichten durch solche des entgegengesetzten Leitungstyps ersetzt werden, wobei die zugeführten Spannungen durch solche des entgegengesetzten Vorzeichens zu ersetzen sind.

**Ansprüche**

1. Abschaltbarer Thyristor mit einem Halbleiterkörper (1), der vier aufeinanderfolgende Halbleiterschichten unterschiedlichen Leitungstyps aufweist, die jeweils den Emitter eines ersten Leitungstyps, eine Basis (6) eines zweiten Leitungstyps, eine Basis (7) des ersten Leitungstyps und einen Emitter (8) des zweiten Leitungstyps bilden, bei dem der Emitter des ersten Leitungstyps in eine Vielzahl von Emittergebieten (2 bis 5) aufgeteilt ist, die in die Basis (6) des zweiten Leitungstyps so eingefügt sind, daß sie sich bis zu einer ersten Hauptfläche (1a) des Halbleiterkörpers (1) erstrecken und in dieser von ersten Elektroden (10 bis 13) kontaktiert werden, die über individuell zugeordnete Widerstandselemente (Rv) mit einem ersten Hauptanschluß (K) verbunden sind, bei dem der Emitter (8) des zweiten Leitungstyps in einer zweiten Hauptfläche (1b) von einer zweiten Elektrode (9) kontaktiert wird, die mit einem zweiten Hauptanschluß (A) verbunden ist und bei dem in der ersten Hauptfläche (1a) neben jedem Emittergebiet (2 bis 5) eine diesem zugeordnete dritte Elektrode (14 bis 17) vorgesehen ist, über die jeweils ein Abschaltstrompfad (18 bis 21) von der Basis (6) des zweiten Leitungstyps zum ersten Hauptanschluß (K) hin verläuft, wobei der Abschaltstrompfad (20) ein Schaltelement (T3) enthält, das ihn beim Abschalten des Thyristors wirksam schaltet, **dadurch gekennzeichnet,** daß jeder Abschaltstrompfad (20) einen ihm individuell zugeordneten Feldeffekttransistor (T3) als Schaltelement enthält und daß die Feldeffekttransistoren (T1 bis T4) aller Abschaltstrompfade einen gemeinsamen Gateanschluß (24) aufweisen, der mit einem Löschimpuls beaufschlagt wird.

2. Abschaltbarer Thyristor nach Anspruch 1, **dadurch gekennzeichnet,** daß der zur Wirksamschaltung eines Abschaltstrompfades (20) dienende Feldeffekttransistor (T3) aus einer in die Basis (6) des zweiten

4

Leitungstyps neben einem Emittergebiet (4) des ersten Leitungstyps eingefügten Halbleiterzone (29) des ersten Leitungstyps, aus einem in diese eingebetteten, ein Draingebiet darstellenden Halbleitergebiet (30) des zweiten Leitungstyps und aus einem an diese Halb leiterzone (29) angrenzenden, ein Sourcegebiet darstellenden Teil (6a) der Basis (6) des zweiten Leitungstyps besteht, daß das in die Halbleiterzone (29) eingefügte Halbleitergebiet (30) in der ersten Hauptfläche (1a) von einer leitenden Belegung (31) kontaktiert wird, die mit dem ersten Hauptanschluß (K) verbunden ist, und daß der zwischen dem in die Halbleiterzone (29) eingebettete Halbleitergebiet (30) und dem an diese Halbleiterzone (29) angrenzenden Teil (6a) der Basis (6) des zweiten Leitungstyps liegende Randbereich der Halbleiterzone (29) das Kanalgebiet darstellt und von einer Gateelektrode (32) überdeckt wird, die durch eine erste dünne, elektrisch isolierende Schicht (33) von der ersten Hauptfläche (1a) des Halbleiterkörpers (1) getrennt ist.

3. Abschaltbarer Thyristor nach Anspruch 1 oder 2, **dadurch gekennzeichnet,** daß auf der ersten Hauptfläche (1a) eine zweite, elektrisch isolierende Schicht (37) aufgebracht ist, daß auf dieser eine Belegung (39) aus widerstandsbehaftetem Material angeordnet ist, die ein Emittergebiet (4) im Bereich eines Kontaktloches (38) der zweiten elektrisch isolierenden Schicht (37) kontaktiert, daß auf dieser Belegung (39) eine dritte, elektrisch isolierende Schicht (40) vorgesehen ist, die mit einem Kontaktloch (41) versehen ist, und daß die Belegung (39) aus widerstandsbehaftetem Material im Bereich dieses Kontaktloches (41) von einer leitenden Belegung (31) kontaktiert wird, die mit dem ersten Hauptanschluß (K) verbunden ist.

4. Abschaltbarer Thyristor nach Anspruch 3, **dadurch gekennzeichnet,** daß die Belegung (39) aus widerstandsbehaftetem Material aus polykristallinem Silizium gebildet ist.

5. Abschaltbarer Thyristor nach einem der Ansprüche 2 bis 4, **dadurch gekennzeichnet,** daß die Gateelektrode (32) aus polykristallinem Silizium gebildet ist.

6. Abschaltbarer Thyristor nach einem der Ansprüche 2 bis 5, **dadurch gekennzeichnet,** daß in die Basis (6) des zweiten Leitungstyps unterhalb des in die Halbleiterzone (29) eingefügten Halbleitergebiets (30) eine Abschirmzone (36) eingefügt ist.

FIG 1

FIG 2